# EUROPÄISCHE PATENTSCHRIFT

(11) **EP 0 621 685 B1**
(45) Veröffentlichungstag und Bekanntmachung des Hinweises auf die Patenterteilung: **12.01.2000**
(21) Anmeldenummer: 94105923.0
(22) Anmeldetag: 16.04.1994
(51) Int. Cl.: H03G 3/20, H04B 7/005

(54) **HF-Verstärker mit Signalpegelregelung und damit ausgestatteter Funksender**
RF-amplifier with level control and radio transmitter including the same
Amplificateur radiofréquence avec contrôle de niveau du signal et émetteur radio utilisant un tel amplificateur

(30) Priorität: 22.04.1993 DE 4313152
(43) Veröffentlichungstag der Anmeldung: 26.10.1994
(73) Patentinhaber: ALCATEL, 75008 Paris (FR)
(72) Erfinder: Haberland, Bernd, D-70186 Stuttgart (DE); Hoen, Günther, D-71254 Ditzingen (DE); Wölfle, Ralf, D-70569 Stuttgart (DE)
(74) Vertreter: Knecht, Ulrich Karl, Dipl.-Ing.

(56) Entgegenhaltungen:
- EP-A- 0 412 392
- EP-A- 0 468 507

## Beschreibung

Die Erfindung betrifft einen HF-Verstärker gemäß dem Oberbegriff des Anspruchs 1 und einen Funksender mit einem derartigen HF-Verstärker gemäß dem Oberbegriff des Anspruchs 7.

Aus EP 0 468 507 Al ist ein HF-Verstärker für ein Mobilfunksender bekannt, der TDMA-Funksignale sendet, wobei für jeden TDMA-Zeitschlitz ein vorgegebener Funksignalpegel eingestellt wird. Demnach dient der HF-Verstärker zur geregelten Änderung des Signalpegel-Verlaufs eines in aufeinanderfolgende Zeitabschnitte (Zeitschlitze) unterteilten HF-Signals, insbesondere eines TDMA-Funksignals. Der bekannte HF-Verstärker hat eine Regelschaltung, die innerhalb mehrerer Teilabschnitte des jeweiligen Zeitabschnittes, in denen jeweils ein bestimmter Soll-Signalpegel-Verlauf vorgegeben ist, den Ist-Signalpegel-Verlauf des HF-Signals unterschiedlich auswertet. Jeder Zeitabschnitt (Zeitschlitz) wird in zwei Teilabschnitte aufgeteilt, wobei nur innerhalb des ersten Teilabschnittes, nämlich innerhalb der sogenannten "non-modulated wave output period", der Sendesignalpegel eingestellt wird. Die Regelschaltung des HF-Verstärkers ermittelt fortlaufend den Mittelwert des Sendesignales, den sie dann zur Skalierung des Ausgangs-lstpegels heranzieht, indem dieser skalierte Istwert mit einem vorgegeben Sollwert verglichen wird, um so den HF-Verstärker nachzuregeln. Der bekannte HF-Verstärker ändert demnach den Signalspegel-Verlauf des Funksignals während des ersten Teilabschnitts eines jeden Zeitschlitzes, d.h. unmittelbar nach dem Übergang von dem jeweils vorherigen zum aktuellen Zeitschlitz. Für Zeitschlitzwechsel mit hoch dynamischen Signalpegeländerungen, kann die Regelung des bekannten HF-Verstärkers daher nicht immer schnell genug reagieren und somit eine stabile Regelung sicherstellen.

Ein HF-Verstärker ähnlicher Art ist beispielsweise aus der EP 0 096 820 B1 bekannt. Dort wird ein Hochfrequenz-Leistungsverstärker vorgestellt, der mittels einer digitalen Regelschleife HF-Träger-Signale zu impulsförmigen Funksignalen mit einer fest vorgegebenen Impulsform moduliert und verstärkt. Demnach werden gleichartige und zeitlich aufeinanderfolgende HF-lmpulse erzeugt. Ein fortlaufender Soll-lst-Vergleich innerhalb der Regelung korrigiert die HF-lmpulse, da ihr Signalpegel-Verlauf bei der Verstärkung stark verzerrt wird. Es werden Zwischenspeicher verwendet, so daß die Korrektur in den Pulspausen durchgeführt werden kann. In diesem Fall ist die Regelschleife während der Korrektur unterbrochen, und man erhält, insbesondere bei Erzeugung gleichartiger HF-lmpulse, eine hohe Stabilität der gesamten Regelung.

Aus WO 92/04771 ist ein Leistungsverstärker für ein TDMA-Funksignal (TDMA: Time Division Multiple Access, Zugriffsverfahren im Zeitvielfach) bekannt, dessen Leistung sich zeitabschnittsweise ändert, d.h. der Signalpegel-Verlauf des TDMA-Funksignals wird für jeden Zeitabschnitt (Zeitschlitz) neu vorgegeben. Der beschriebene Leistungsverstärker ist insbesondere für den Einsatz in Funksendern für Mobilfunk nach dem GSM-Standard (GSM: Global System for Mobile Communication) vorgesehen. Der Leistungsverstärker wird dynamisch geregelt, so daß der Leistungspegel des TDMA-Funksignals sich von Zeitabschnitt zu Zeitabschnitt auf einen neu vorgegebenen Sollwert einstellt. Die Leistungsregelung wird mittels digitaler Schaltkreise, die den Signalpegel des Funksignals ändern, bewirkt.

Aufgabe der Erfindung ist der Entwurf eines sehr stabil geregelten HF-Verstärkers zur geregelten Änderung des Signalpegel-Verlaufs eines HF-Signals, insbesondere eines TDMA-Funksignals, dessen Soll-Signalpegel-Verlauf von einem Zeitabschnitt zum nachfolgenden neu vorgegeben wird.

Diese Aufgabe wird gelöst durch einen HF-Verstärker mit den Merkmalen des Anspruchs 1. Nach Anspruch 1 ist ein HF-Verstärker mit einer digitalen Regelschleife vorgesehen, die den Signalpegelverlauf eines HF-Signales zeitabschnittsweise innerhalb mehrerer Teilbereiche auf unterschiedliche Art und Weise auswertet und somit eine geregelte Änderung des Signalpegel-Verlaufs dieses HF-Signales bewirkt. Die verbesserte Regelschaltung wertet dazu im jeweiligen Zeitabschnitt innerhalb eines ersten Teilbereiches, in dem ein dynamischer Soll-Signalpegel-Verlauf vorgegeben ist, den Ist-Signalpegel-Verlauf nicht aus, und wertet innerhalb eines zweiten Teilbereiches, in dem ein konstanter Soll-Signalpegel-Verlauf vorgegeben ist, den Ist-Signalpegel-Verlauf aus, indem die Regelschaltung mittels eines Soll-lst-Vergleichs einen Konstant-Fehlerwert ermittelt.

Der Ist-Signalpegel-Verlauf wird also während eines jeden Zeitabschnitts (Zeitschlitzes) innerhalb der Regelung differenziert erfaßt, indem der jeweilige Zeitabschnitt in mehrere Teilbereiche unterteilt wird, die jeweils einen charakteristischen Ist-Signalpegel-Verlauf kennzeichnen, d.h. indem etwa zwischen einem statischen Teilbereich und einem dynamischen Teilbereich differenziert wird. Die teilabschnittsweise unterschiedlichen Auswertungen können an den entsprechenden charakteristischen Ist-Signalpegel-Verlauf so angepaßt werden, daß z.B. trotz Teilbereichen mit einer großen Signalpegeldynamik eine sehr stabile Regelung bewirkt wird. Nach Anspruch 7 wird ein Funksender mit einem solchen HF-Verstärker bereitgestellt.

Vorteilhafte Weiterbildungen sind den Unteransprüchen zu entnehmen.

Es folgt nun die Beschreibung der Erfindung anhand eines Ausführungsbeispiels für eine Funkfeststation im GSM und unter Zuhilfenahme der bei beiliegenden Zeichnungen.
- Fig. 1a): zeigt den Aufbau eines TDMA-Funksignales, wie er nach dem GSM-Standard gefordert wird,
- Fig. 1b): zeigt einen typischen Signalpegel-Verlauf für dieses TDMA-Funksignal und seine erfindungsgemäße Unterteilung in Teilbereiche,
- Fig. 2: zeigt einen HF-Verstärker zur geregelten Änderung des Signalpegel-Verlaufs dieses TDMA-Funksignals.

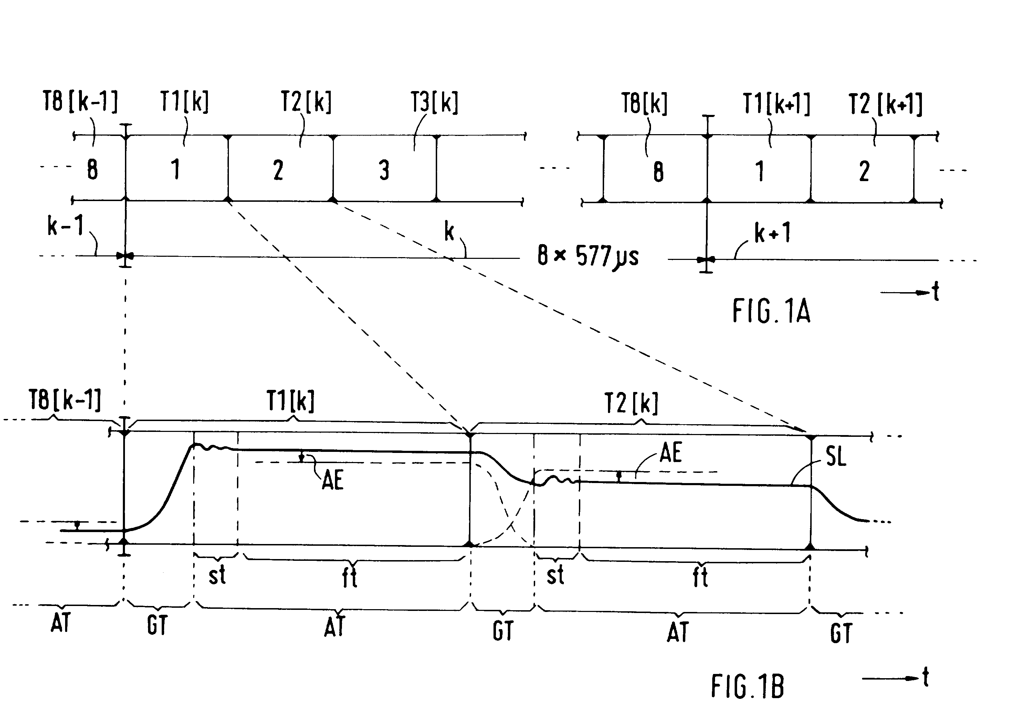

Der in Fig. 1a dargestellte Aufbau eines von der Funkfeststation gesendeten TDMA-Funksignals zeigt dessen Unterteilung in acht aufeinanderfolgende Zeitabschnitte T1[k], T2[k] ... T8[k]. Jeder Zeitabschnitt (Zeitschlitz) repräsentiert einen Funkkanal, auf den mittels TDMA-Verfahren jeweils ein Mobilfunkteilnehmer Zugriff hat. Acht Zeitabschnitte, welche auch Zeitschlitze genannt werden, bilden einen Zeitrahmen k. Die zyklische Abfolge von Zeitschlitz zu Zeitschlitz wird zeitrahmensweise im Abstand von 8•577 µs = 4,6 ms wiederholt. Innerhalb von TDMA-Funksendern stellt üblicherweise ein HF-Verstärker die Leistung des TDMA-Funksignales zeitabschnittsweise auf die jeweilige Funkverbindung ein. Entsprechende Änderungen des Signalpegels haben beispielsweise nach GSM-Standard eine Dynamik von max. 30 dB.

In Fig. 1b) ist ein entsprechender Signalpegel-Verlauf von einem Zeitabschnitt T8[k-1] eines vorhergehenden Zeitrahmens bis zu einem Zeitabschnitt T2[k+1] des nachfolgenden Zeitrahmens dargestellt. Der gezeigte Signalpegel-Verlauf SL entspricht dem Ist-Signalpegel-Verlauf am Ausgang des HF-Leistungsverstärkers eines TDMA-Funksenders. Am Beispiel zweier, aufeinanderfolgender Zeitabschnitte T1[k] und T2[K] wird die erfindungsgemäße Unterteilung in mehrere Teilbereiche dargestellt.

Beispielhaft wird hier eine Unterteilung eines jeden Zeitabschnittes in einen ersten Teilbereich GT, der den dynamischen Signalpegel-Verlauf umfaßt, und in einen zweiten Teilbereich AT, der den statischen Signalpegel-Verlauf umfaßt, gezeigt. Demnach umfaßt der zweite Teilbereich AT des jeweiligen Zeitabschnittes einen Zeitbereich, in dem der Signalpegel-Verlauf SL konstant gehalten werden soll. Der tatsächliche Ist-Signalpegel am Ausgang des HF-Verstärkers darf nach GSM-Empfehlungen mit maximal ±1dB um einen konstanten Pegelwert schwanken. Der erste Teilbereich GT des jeweiligen Zeitabschnitts erstreckt sich über einen Zeitbereich, in dem der Signalpegel von dem konstanten Pegelwert des vorhergehenden Zeitabschnitts auf den neuen Pegelwert dynamisch angepaßt wird. Dieser Übergangsbereich kann insbesondere dann eine hohe Signalpegeldynamik von 70dB und mehr aufweisen, wenn eine zeitabschnittsweise Signalpegeländerung von oder zum Nullpegel erfolgen soll.

Die gezeigten Teilbereiche GT und AT umfassen charakteristische Signalpegel-Verläufe innerhalb eines jeden Zeitabschnittes. Der erfindungsgemäße HF-Verstärker regelt die Änderung des Signalpegels unter der Berücksichtigung, daß teilabschnittsweise solche unterschiedlichen, je für sich charakteristischen Signalpegel-Verläufe existieren. In diesem Ausführungsbeispiel wird demnach ein Konstant-Fehlerwert AE ermittelt, der die Abweichung des tatsächlichen Signalpegels innerhalb des zweiten Teilbereiches AT von einem vorgegebenen festen Signalpegelwert darstellt. Innerhalb des ersten Teilbereichs GT werden keine Fehlerwerte direkt ermittelt. Die Abweichung des Ist-Signalpegel-Verlaufs vom vorgegebenen, z.B. cos²-förmigen Soll-Signalpegel-Verlauf wird für den ersten, dynamischen Teilbereich GT aus den beiden Konstant-Fehlerwerten der benachbarten Teilbereiche abgeleitet.

Die gezeigte Unterteilung des jeweiligen Zeitabschnittes verdeutlicht das differenzierte Regelverhalten des HF-Verstärkers innerhalb des ersten Teilbereichs GT, der dein Übergangsintervall entspricht und innerhalb des zweiten Teilbereichs AT, der dem Nutzintervall des Funksignals entspricht. Um die Regelung noch weiter zu verbessern, wird jeweils der zweite Teilbereich AT in zwei Sub-Teilbereiche st und ft unterteilt.

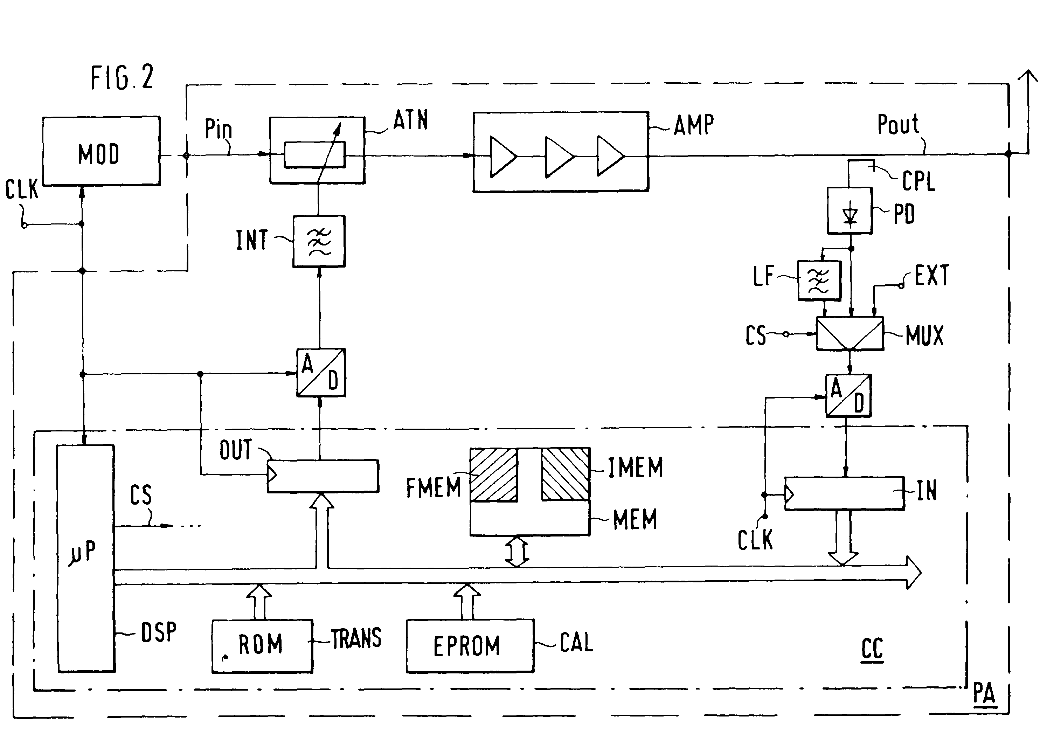

Eine genaue Beschreibung, wie der HF-Verstärker arbeitet, folgt im weiteren und unter Zuhilfenahme der Fig. 2:

Dazu ist in Fig. 2 die Modulations-Stufe MOD eines Funksenders mit einem nachgeschalteten HF-Verstärker PA dargestellt, der die Leistung eines TDMA-Funksignals regelt. Der Funksender ist Teil einer Funkfeststation für Mobilfunk nach dem GSM-Standard und strahlt ein TDMA-Funksignal ab, dessen Leistungspegel von einem Zeitabschnitt zum nächsten neu vorgegeben wird. Dieses TDMA-Funksignal wird mittels des HF-Verstärkers wie folgt gebildet: Ein aus der Modulations-Stufe MOD kommendes und mit einem TDMA-Signal moduliertes HF-Signal Pin mit einem konstanten Leistungspegel wird auf ein steuerbares Dämpfungsglied ATN zur Hüllkurvenmodulation gegeben und anschließend in eine Endverstärker-Stufe AMP eingespeist. Das leistungsverstärkte HF-Signal Pout verläßt als TDMA-Funksignal mit einem von Zeitschlitz zu Zeitschlitz neu vorgegebenen Leistungspegel, den HF-Verstärker und wird auf eine Antenne geführt. Ein Bruchteil des leistungsverstärkten HF-Signals Pout wird mittels eines Richtkopplers CPL in einen nachfolgend näher beschriebenen Regelkreis eingespeist. Dieser Regelkreis verändert die Dämpfung des steuerbaren Dämpfungsgliedes ATN derat, daß sich der Signalpegel des HF-Signales entsprechend dem jeweiligen von Zeitabschnitt zu Zeitabschnitt neu vorgegebenen Sollwert ändert.

Der mittels des Richtkopplers CPL ausgekoppelte Signalanteil des leistungsverstärkten HF-Signals Pout wird auf einen Hüllkurvendetektor PD geführt, der ein Meßsignal erzeugt, das entsprechend dem tatsächlichen Leistungspegel des HF-Signals Pout verläuft. Dieses Meßsignal wird direkt und parallel dazu über ein Tiefpaßfilter LF auf einen Analog-Multiplexer MUX geführt. Weiterhin liegt ein externes Überwachungs-Signal EXT an einem der Eingänge dieses Analog-Mulitplexers MUX an. Das Ausgangssignal des Analog-Multiplexers MUX wird mittels eines Analog-Digital-Umsetzers digitalisiert und von einer prozessorgesteuerten Digitalschaltung CC gelesen. Die prozessorgesteuerte Digitalschaltung CC speichert das digitalisierte Ausgangssignal des Analog-Multiplexers MUX in einem Eingabe-Pufferspeicher IN ab, indem pro Zeitabschnitt z.B. 52 Abtastwerte erfaßt werden. Ausgangsseitig hat die prozessorgesteuerte Digitalschaltung CC einen entsprechenden Ausgabe-Pufferspeicher OUT, der digitale Steuersignale bereitstellt, die mittels eines Digital-Analog-Umsetzers und einem diesem nachgeschalteten Integrator INT auf den Steuereingang des Dämpfungsgliedes ATN geführt werden.

Die prozessorgesteuerte Digitalschaltung CC enthält als Herzstück einen Signalprozessor DSP, der über die genannten Pufferspeicher in den Regelkreis integriert ist. Als Prozessor eignet sich z.B. der Typ 561001 von der Firma Motorola Inc.. Weiterhin enthält sie einen Arbeitsspeicher MEM, einen Festwert-Speicher TRANS und einen Kennlinien-Speicher CAL. Alle genannten Komponenten der prozessorgesteuerten Digitalschaltung CC sind mittels eines Adress- und Datenbusses miteinander verbunden und wirken wie folgt zusammen: Während eines jeden Zeitabschnittes wird der Ist-Signalpegel-Verlauf des leistungsverstärkten HF-Signals Pout abgetastet. Es werden zeitabschnittsweise nur Abtastwerte aus dem statischen Teilbereich AT, im folgenden Ist-Signalpegel-Werte genannt, in den Eingabe-Pufferspeicher IN gelesen und für die Leistungsregelung ausgewertet. Jeweils die Ist-Signalpegel-Werte der beiden abgetasteten Zeitabschnitte befinden sich im Eingabe-Pufferspeicher. Mittels Soll-Ist-Vergleich wird zeitabschnittsweise jeweils ein Konstant-Fehlerwert AE ermittelt. Der dynamische Teilbereich GT eines jeden Zeitabschnitts wird nicht ausgewertet, aber mittels bestimmter Konstant-Fehlerwerte korrigiert, wie noch genauer beschrieben wird.

Jeweils der Konstant-Fehlerwert eines bestimmten Zeitabschnittes, wie z.B. T2[k], wird bei der Steuerung des statischen Teilbereiches AT des entsprechenden Zeitabschnittes innerhalb des nachfolgenden TDMA-Zeitrahmens herangezogen, d.h. in diesem Beispiel bei der Steuerung des statischen Teilbereiches AT von T2[k+1].

Jeweils die Konstant-Fehlerwerte zweier benachbarter Zeitabschnitte, wie z.B. T1[k] und T2[k], dienen zur Korrektur des dynamischen Teilbereiches GT des entsprechenden Übergangsbereichs innerhalb des nachfolgenden TDMA-Zeitrahmens, d.h. in diesem Beispiel zur Korrektur des dynamischen Teilbereiches GT von T2[k+1]. Durch diese adaptive Korrektur entfällt eine aufwendige direkte Regelung der dynamischen Teilbereiche. Im Eingabe-Pufferspeicher befinden sich jeweils die Ist-Signalpegel-Werte des Zeitabschnittes, der zuletzt abgetastet wurde, und die des vorangegangenen Zeitabschnittes, d.h. in diesem Beispiel und entsprechend Fig. 1a) die Ist-Signalpegel-Werte der Zeitabschnitte T2[k] und T1[k]. Die Auswertung der Ist-Signalpegel-Werte führt zu Steuerwerten für die entsprechenden Zeitabschnitte T1[k+1] und T2[k+1] des nachfolgenden TDMA-Zeitrahmens. Bezogen auf jeweils einen Zeitabschnitt ist die Regelung für die Dauer eines ganzen TDMA-Zeitrahmens unterbrochen. Die prozessorgesteuerte Digitalschaltung CC bewirkt somit eine stabile Leistungsregelung, so daß Nichtlinearitäten und Temperaturdrift der Endverstärker-Stufe AMP und des Dämpfungsglieds ATN korrigiert werden.

Zur genaueren Beschreibung der Arbeitsweise der prozessorgesteuerten Digitalschaltung CC werden nun folgende zwei Fälle betrachtet:
1) Im zyklischen Fall befindet sich die Regelung in einem eingeschwungenen Zustand und der zu regelnde Signalpegel-Verlauf des HF-Signales verläuft zeitrahmensweise gleichartig. In diesem Fall ist jeweils einem Zeitabschnitt ein bestimmter Mobilfunkteilnehmer eindeutig zugeordnet, so daß der Signalpegel-Verlauf innerhalb eines Zeitrahmens musterhaft für die nachfolgenden Zeitrahmen ist. Jedem Zeitabschnitt ist ein Leistungssignalpegel zugeordnet, der innerhalb des entsprechenden statischen Teilbereiches AT eingehalten werden soll. Die jeweiligen dynamischen Teilbereiche GT bilden Übergangsbereiche, in denen der Signalpegel entsprechend einer cos²-Kurve geändert wird. Die prozessorgesteuerte Digitalschaltung CC errechnet die Steuerwerte zur Ansteuerung des Dämpfungsgliedes ATN jeweils für einen kommenden Zeitabschnitt (z.B. T2[k+1]), nachdem jeweils die Ist-Signalpegel-Werte des entsprechenden Zeitabschnittes T2[k] im vorangegangenen Zeitrahmen detektiert wurden.
   Die Ist-Signalpegel-Werte werden mittels Abtastung wie folgt gewonnen: Der Signalprozessor DSP steuert den Analog-Multiplexer MUX mittels eines Steuersignales CS zu Beginn eines jeden Zeitabschnittes so, daß während des zweiten, statischen Teilbereiches AT (siehe Fig. 1b) das tiefpaßgefilterte, detektierte Signal abgetastet wird. Die Tiefpaßfilterung glättet den detektierten Ist-Signalpegel-Verlauf und eliminiert so hochfrequente Störungen, wie beispielsweise eine Restamplitudenmodulation des HF-Signals Pout. Bei der Auswertung der entsprechenden Ist-Signalpegel-Werte werden Pegelschwankungen, die während der Einschwingphase st des Tiefpaßfilters LF auftreten, nicht mitberücksichtigt. Von den erfaßten Ist-Signalpegel-Werten werden nur diejenigen aus der nachfolgenden, stabilen Ruhephase ft des Filters (siehe Fig. 1b) ausgewertet, z.B. 12 von 52 Abtastwerten.
   Über die in diesem Beispiel verbleibenden 12 Abtastwerte wird linear gemittelt. Die anhand der im Kennlinien-Speicher CAL abgelegten Kennlinien-Daten des Hüllkurvendetektors PD dienen zur Konvertierung der Abtastwerte vom Spannungsbereich in den Leistungsbereich. Anschließend wird über die konvertierten Abtastwerte linear gemittelt. Der errechnete Mittelwert repräsentiert demnach den mittleren Leistungspegel des HF-Signals Pout innerhalb des zweiten, statischen Teilbereichs AT des Zeitabschnitts T2[k]. Ein Vergleich dieses korrigierten Mittelwertes mit dem Konstant-Soll-Pegelwert für diesen Teilbereich, der im Arbeitsspeicher MEM abgelegt ist, ergibt einen Konstant-Fehlerwert AE, der die Pegelabweichung des HF-Signals Pout in diesem statischen Teilbereich kennzeichnet. Der Konstant-Soll-Pegelwert für den jeweils einzustellenden Zeitabschnitt wird von einer hier nicht dargestellten digitalen Einheit, der sogenannten frame unit, bereitgestellt. Diese frame unit gibt u.a. die einzustellende Leistungspegelstufe entsprechend der aktuellen Belegung der Zeitschlitze vor.
   Die prozessorgesteuerte Digitalschaltung CC korigiert mittels des ermittelten Konstant-Fehlerwertes AE des jeweils zuletzt erfaßten Zeitabschnittes T2[k] den Konstant-Soll-Pegelwert für den entsprechenden Zeitabschnitt T2[k+1] im nachfolgenden Zeitrahmen zu einem Konstant-Steuerwert. Dieser wird in einem Zeitrahmen-Speicher FMEM abgelegt, der ein Teil des Arbeitsspeichers MEM ist. Innerhalb der statischen Teilbereiche im nachfolgenden Zeitrahmen wird das Dämpfungsglied ATN mittels der entsprechenden Konstant-Steuerwerte gesteurt, die jeweils für die Dauer eines Zeitrahmens im Zeitrahmen-Speicher abgelegt sind. Der Konstant-Steuerwert für einen statischen Teilbereich repräsentiert in dieser Beschreibung die jeweils notwendigen, gleichen Digitalwerte (z.B. 27 Digitalwerte) zur Ansteuerung des Digital-Analog-Umsetzers. Der jeweilige zweite Teilbereich AT ist durch seinen Konstant-Steuer-Wert gekennzeichnet, der die jeweils zeitabschnittsweise einzustellende Leistungspegelstufe bestimmt. Der Übergang von dieser Leistungspegelstufe zur nachfolgenden findet im ersten Teilbereich GT statt. Die Steuerwerte für diesen transienten Signalpegelverlauf werden mittels der Konstant-Steuerwerte für die entsprechenden Leistungspegelstufen und mittels Daten aus dem Festwertspeicher TRANS berechnet. Die Daten kennzeichnen eine cos²-förmige Normkurve und werden durch Wichtungsfaktoren an die geforderte Dynamik des jeweiligen Leistungspegelstufen-Übergangs, d.h. an die Differenz der beiden Konstant-Steuerwerte, angepaßt. Die gewichteten Normkurven-Daten bilden die Steuerwerte, die diesen transienten Signalabschnitt charakterisieren und im folgenden Dynamik-Steuerwerte genannt werden.
   Die z.B. 25 ermittelten Dynamik-Steuerwerte werden gleichfalls für eine Zeitrahmendauer im Zeitrahmenspeicher FMEM abgelegt. Die Berechnung der Dynamik-Steuerwerte entfällt, falls die entsprechenden Konstant-Steuerwerte sich von Zeitrahmen zu Zeitrahmen nicht ändern, d.h., falls sich ein stabiler Signalpegel-Verlauf einstellt. In diesem Fall bleibt der Inhalt des Rahmenspeichers FMEM unverändert.
   Der beschriebene HF-Verstärker PA regelt den Signalpegel des HF-Signals sehr stabil, weil u.a. die Regelung zwischen solchen verschiedenen, zeitlichen Teilbereichen differenziert, in denen der Signalpegel jeweils typisch verläuft. So bewirkt beispielsweise die Tiefpaßfilterung innerhalb des zweiten Teilbereichs AT eine stabile Regelung dieses statischen Teilbereichs. Der zweite, dynamische Teilbereich GT wird vorteilhaft dadurch geregelt, daß die dazu notwendigen Dynamik-Steuerwerte an die entsprechenden Konstant-Steuerwerte angepaßt werden.
   Neben der Auswertung des detektierten Signalpegels wird auch das externe Überwachungs-Signal EXT, welches in dem Analog-Multiplexer MUX eingespeist wird, mittels der prozessorgesteuerten Digitalschaltung CC ausgewertet. Dieses externe Überwachungssignal EXT kann beispielsweise von einem Temperatursensor bereitgestellt werden, der die Endverstärker-Stufe AMP überwacht. Im Fall einer Überhitzung wird ein Alarmsignal mittels des Signalprozessors DSP generiert. Vorteilhaft ist auch eine Überwachung des HF-Abschlusses am Verstärkerausgang, d.h. die korrekte Verbindung zur Antenne, so daß keine HF-Leistung auf den Verstärkerausgang reflektiert wird. Hierzu könnte eine entsprechende Zirkulator-Stufe ein weiteres externes Überwachungssignal in den Regelkreis einspeisen. Wie in Fig. 2 dargestellt, werden die prozessorgesteuerte Digitalschaltung CC wie auch die Modulations-Stufe MOD, welche sich am Eingang des HF-Verstärkers PA befindet, von gemeinsamen Taktsignalen getaktet. Somit ist eine Synchronisation des burstmodulierten HF-Signales mit dem digitalen Teil der Regelstrecke gewährleistet.
2) Im nichtzyklischen Fall ist eine gleichartige Wiederholung des Signalpegelverlaufs von einem Zeitrahmen zum nächsten nicht gewährleistet. Dies ist im allgemeinen Betriebszustand des gezeigten HF-Verstärkers für eine GSM-Funkfeststation zu erwarten, da von Zeitrahmen zu Zeitrahmen einzelne oder auch mehrere Zeitabschnitte neuen Mobilfunkteilnehmern zugeordnet werden (z.B. durch Frequency Hopping und Power Control). Weiterhin sind einzelne Zeitabschnitte nicht immer belegt, so daß in diesem Zeitabschnitt keine Nutzsendeleistung gefordert ist. Vorteilhaft ist hier eine zeitabschnittsweise Abschaltung der Endverstärker-Stufe AMP, um unnötige Abstrahlung über die Antenne zu vermeiden.

Im nichtzyklischen Fall müssen zeitrahmenweise stets neue Dynamik-Steuerwerte für den jeweiligen Übergang von einem statischen Teilbereich zum nächsten bereitgestellt werden. Eine jeweilige Berechnung und Anpassung mittels der im Festwertspeicher TRANS abgelegten Daten wird vorteilhaft wie folgt vermieden: Wird erstmalig ein bestimmter Übergang von einem Leistungspegel zu einem anderen gefordert, so werden die Dynamik-Steuerwerte, die diesen Übergang charakterisieren, ermittelt und in einem Initialisierungs-Speicher IMEM abgelegt. Diese Dynamik-Steuerwerte können jederzeit aus dem Initialisierungs-Speicher abgerufen werden, falls der entsprechend gleiche Übergang innerhalb eines anderen zweiten Teilbereiches GT gefordert wird. Um den Speicheraufwand zu reduzieren, werden nur solche Dynamik-Steuerwerte im Initialisierungs-Speicher abgelegt, die den Übergang von oder zu einem Nullpegel, d.h. einem nicht besetzten Zeitabschnitt, bestimmt. Für z.B. 16 mögliche Leistungsstufen sind demnach 32 Übergangsfunktionen denkbar. Für jede geforderte Übergangsfunktion wird ein bestimmter Satz von 25 Dynamik-Steuerwerten unter einer charakteristischen Adresse im Initialisierungs-Speicher IMEM abgelegt. Dies kann bei Inbetriebnahme des Verstärkers erfolgen. Während des Betriebs können Abweichungen bezüglich der 16 Leistungsstufen anhand der Konstant-Fehlerwerte (AE) festgestellt werden und zur Korrektur der in IMEM abgelegten Dynamik-Steuerwerte herangezogen werden.

Ein möglichst harmonischer Übergang vom Nullpegel zu einer Leistungsstufe oder umgekehrt ist unterhalb eines gewissen Leistungspegelunterschieds von z.B. -30 dBc nicht zwingend erforderlich, so daß hier keine Berechnung von Dynamik-Steuerwerten benötigt wird. Ein abruptes An- oder Abschalten des Verstärkers verursacht im Bereich geringer Ausgangsleistung des HF-Signals nur eine zu vernachlässigende spektrale Störung. Die Regelung kann entsprechend weiter optimiert werden.

Der hier beschriebene HF-Verstärker ist insbesondere zur Leistungsregelung eines TDMA-Funksignales nach GSM-Standard geeignet. Er stellt nur eine besonders vorteilhafte Ausführungsform des erfindungsgemäßen HF-Verstärkers dar. Eine Vielzahl weiterer Ausführungsformen, wie z.B. ein hochdynamischer HF-Leistungsverstärker für Sekundarradaranlagen, in dem bestimmte Impulsintervalle verstärkt werden, ist denkbar.

## Patentansprüche

1. HF-Verstärker (PA) zur geregelten Änderung des Signalpegel-Verlaufs (SL) eines in aufeinanderfolgende Zeitabschnitte (T1, T2, ..., T8) unterteilten HF-Signals (Pin, Pout), insbesondere eines TDMA-Funksignals, mit einer Regelschaltung (CC), die innerhalb mehrerer Teilabschnitte (GT, AT) des jeweiligen Zeitabschnittes (T1, T2), in denen jeweils ein bestimmter Soll-Signalpegel-Verlauf vorgegeben ist, den Ist-Signalpegel-Verlauf des HF-Signals (Pout) unterschiedlich auswertet,
**dadurch gekennzeichnet,**
daß die Regelschaltung (CC) im jeweiligen Zeitabschnitt (T1[k]; T2[k]) innerhalb eines ersten Teilbereiches (GT), in dem ein dynamischer Soll-Signalpegel-Verlauf vorgegeben ist, den Ist-Signalpegel-Verlauf nicht auswertet, und innerhalb eines zweiten Teilbereiches (AT), in dem ein konstanter Soll-Signalpegel-Verlauf vorgegeben ist, den Ist-Signal pegel-Verlauf auswertet, indem die Regelschaltung (CC) mittels eines Soll-lst-Vergleichs einen Konstant-Fehlerwert (AE) ermittelt.

2. HF-Verstärker (PA) nach Anspruch 1,
dadurch gekennzeichnet, daß der Regelschaltung (CC) ein Tiefpaßfilter (LF) vorgeschaltet ist, das innerhalb des zweiten Teilbereiches (AT) den Ist-Signalpegel-Verlauf glättet und diesen zur Ermittlung des Konstant-Fehlerwertes (AE) bereitstellt.

3. HF-Verstärker (PA) nach Anspruch 1,
dadurch gekennzeichnet, daß die Regelschaltung eine prozessorgesteuerte Digitalschaltung (CC) ist, die innerhalb des zweiten Teilbereiches (AT) aus dem Ist-Signalpegel-Verlauf einen Ist-Mittelwert bestimmt und diesen zur Ermittlung des Konstant-Fehlerwertes (AE) auswertet.

4. HF-Verstärker (PA) nach Anspruch 1,
dadurch gekennzeichnet, daß die Regelschaltung eine prozessorgesteuerte Digitalschaltung (CC) ist,
die den ermittelten Konstant-Fehlerwert (AE) des jeweiligen Zeitabschnitts (T2[k]) zur Steuerung des konstanten Soll-Signalpegel-Verlaufs innerhalb eines späteren Zeitabschnitts (T2[k+1]) heranzieht und,
die die ermittelten Konstant-Fehlerwerte von zwei aufeinanderfolgenden Zeitabschnitten (T1[k]), T2[k]) zur Steuerung des dynamischen Soll-Signalpegel-Verlaufs innerhalb eines späteren Zeitabschnittes (T2[k+1]) heranzieht, um den Übergang von einem Signalpegel zum nachfolgenden anzupassen.

5. HF-Verstärker (PA) nach Anspruch 4 zur leistungsgeregelten Verstärkung eines TDMA-Funksignals, das aus Zeitrahmen (k-1, k, k+1 ...) aufgebaut ist, die jeweils mehrere der Zeitabschnitte (T1[k], T2[k] ... T8[k]) umfassen,
dadurch gekennzeichnet, daß die prozessorgesteuerte
Digitalschaltung (CC) aus den Konstant-Fehlerwerten (AE), die innerhalb eines Zeitrahmens (k) ermittelt werden, Steuerwerte errechnet und diese in einem Zeitrahmen-Speicher (FMEM) zwischenspeichert und zur Steuerung des Soll-Signalpegel-Verlaufs innerhalb eines der nachfolgenden Zeitrahmen (k+1) heranzieht, falls die Soll-Signalpegel-Verläufe in den beiden Zeitrahmen (k, k+1) zumindest annähernd gleich vorgegeben sind.

6. HF-Verstärker (PA) nach Anspruch 4,
dadurch gekennzeichnet, daß die prozessorgesteuerte Digitalschaltung (CC) beim erstmaligen Auftreten eines Signalpegelübergangs Dynamik-Steuerwerte zur Anpassung des dynamischen, ersten Teilbereichs (GT; T2[k+1]) an die benachbarten konstanten, zweiten Teilbereiche (AT; T1[k+1], T2[k+1]) entsprechend einer cos²-Kurve errechnet und diese in einem Initialisierungs-Speicher (IMEM) ablegt und diese Dynamik-Steuerwerte innerhalb eines nachfolgenden ersten Teilbereichs (GT) beim nochmaligen Auftreten dieses Signalpegelübergangs zur Steuerung des dynamischen Soll-Signalpegel-Verlaufs heranzieht.

7. Funksender mit einem HF-Verstärker (PA) zur geregelten Änderung des Signalpegel-Verlaufs (SL) eines in aufeinanderfolgende Zeitabschnitte (T1, T2, ..., T8) unterteilten HF-Signals (Pin, Pout), insbesondere eines TDMA-Funksignals, und mit einer Regelschaltung (CC), die innerhalb mehrerer Teilbereiche (GT, AT) des jeweiligen Zeitabschnittes (T1, T2), in denen jeweils ein bestimmter Soll-Signalpegel-Verlauf vorgegeben ist, den Ist-Signalpegel-Verlauf des HF-Signals (Pout) unterschiedlich auswertet,
**dadurch gekennzeichnet,**
daß die Regelschaltung (CC) im jeweiligen Zeitabschnitt (T1[k]; T2[k]) innerhalb eines ersten Teilbereiches (GT), in dem ein dynamischer Soll-Signalpegel-Verlauf vorgegeben ist, den Ist-Signalpegel-Verlauf nicht auswertet, und innerhalb eines zweiten Teilbereiches (AT), in dem ein konstanter Soll-Signalpegel-Verlauf vorgegeben ist, den Ist-Signalpegel-Verlauf auswertet, indem die Regelschaltung (CC) mittels eines Soll-lst-Vergleichs einen Konstant-Fehlerwert (AE) ermittelt.

## Claims

1. An RF amplifier (PA) for controlling the level characteristic (SL) of an RF signal (Pin, Pout) divided into successive time intervals (T1, T2, ..., T8), particularly of a TDMA radio signal, comprising a control circuit (CC) which evaluates the actual-level characteristic of the RF signal (Pout) differently within two or more subintervals (GT, AT) of the respective time interval (T1, T2), in each of which a particular desired-level characteristic is predefined,
**characterized in**
that the control circuit (CC) does not evaluate the actual-level characteristic within a first subinterval (GT), for which a dynamic desired-level characteristic is predefined, and evaluates the actual-level characteristic within a second subinterval (AT), for which a constant desired-level characteristic is predefined, by determining a constancy error value (AE) by means of a desired-value/actual-value comparison.

2. An RF amplifier (PA) as claimed in claim 1, characterized in that the control circuit (CC) is preceded by a low-pass filter (LF) which smoothes the actual-level characteristic within the second subinterval (AT) and makes the former available for determining the constancy error value (AE).

3. An RF amplifier (PA) as claimed in claim 1,
characterized in that the control circuit is a processor-controlled digital circuit (CC) which determines an actual average value from the actual-level characteristic within the second subinterval (AT), and evaluates said actual average value to determine the constancy error value (AE).

4. An RF amplifier (PA) as claimed in claim 1,
characterized in that the control circuit is a processor-controlled digital circuit (CC) which uses the determined constancy error value (AE) of the respective time interval (T2[k]) to control the constant desired-level characteristic within a subsequent time interval (T2[k+1]), and which uses the determined constancy error values of two successive time intervals (Tl[k], T2[k]) to control the dynamic desired-level characteristic within a subsequent time interval (T2[k+1]) in order to adapt the transition from one signal level to the next.

5. An RF amplifier (PA) as claimed in claim 4 for the power-controlled amplification of a TDMA radio signal consisting of frames (k-1, k, k+1, ...) each comprising a number of time intervals (T1[k], T2[k], ..., T8[k]),
characterized in that the processor-controlled digital circuit (CC) calculates control values from the constancy error values (AE) determined within a frame (k), stores said control values temporarily in a frame memory (FMEM), and uses them to control the desired-level characteristic within one of the subsequent frames (k+1) if the desired-level characteristics in the two frames (k, k+1) are predefined at least approximately equally.

6. An RF amplifier (PA) as claimed in claim 4,
characterized in that on the first occurrence of a signal-level transition, the processor-controlled digital circuit (CC) calculates dynamics control values for adapting the dynamic, first subinterval (GT; T2[k+1]) to the adjoining constant, second subintervals (AT; T1[k+1], T2[k+1]) according to a cos² curve, stores said dynamics control values in an initialization memory (IMEM), and, if said signal-level transition occurs again, uses them to control the dynamic desired-level characteristic within a subsequent first subinterval (GT).

7. A radio transmitter comprising an RF amplifier (PA) for controlling the level characteristic (SL) of an RF signal (Pin, Pout) divided into successive time intervals (T1, T2, ..., T8), particularly of a TDMA radio signal, and comprising a control circuit (CC) which evaluates the actual-level characteristic of the RF signal (Pout) differently within two or more subintervals (GT, AT) of the respective time interval (T1, T2), in each of which a particular desired-level characteristic is predefined,
**characterized in**
that the control circuit (CC) does not evaluate the actual-level characteristic in the respective time interval (Tl[k]; T2[k]) within a first subinterval (GT), in which a dynamic desired-level characteristic is predefined, and evaluates the actual-level characteristic within a second subinterval (AT), in which a constant desired-level characteristic is predefined, by determining a constancy error value (AE) by means of a desired-value/actual-value comparison.

## Revendications

1. Amplificateur radiofréquence (PA) pour la modification régulée de la courbe de niveau de signal (SL) d'un signal radiofréquence (Pin, Pout) divisé en segments temporels qui se suivent (T1, T2, ..., T8), en particulier d'un signal radio TDMA, avec un circuit de régulation (CC) qui, à l'intérieur de plusieurs segments partiels (GT, AT) du segment temporel respectif (T1, T2) dans lesquels à chaque fois une courbe de niveau de signal de consigne est prédéterminée, analyse de façon différente la courbe de niveau de signal effectif du signal radiofréquence (Pout),
caractérisé en ce que
le circuit de régulation (CC) dans le segment temporel respectif (T1[k]; T2[k]) à l'intérieur d'une première zone partielle (GT) dans laquelle une courbe dynamique de niveau de signal de consigne est prédéterminée, n'analyse pas la courbe de niveau de signal effectif et, à l'intérieur d'une deuxième zone partielle (AT) dans laquelle une courbe de niveau de signal de consigne constante est prédéterminée, analyse la courbe de niveau de signal effectif, le circuit de régulation (CC) déterminant une valeur d'erreur constante (AE) au moyen d'une comparaison valeur de consigne/effective.

2. Amplificateur radiofréquence (PA) selon la revendication 1, caractérisé en ce qu'en amont du circuit de régulation (CC) est monté un filtre passe-bas (LF) qui, à l'intérieur de la deuxième zone partielle (AT), lisse la courbe de niveau de signal effectif et fournit celle-ci pour la détermination de la valeur d'erreur constante (AE).

3. Amplificateur radiofréquence (PA) selon la revendication 1, caractérisé en ce que le circuit de régulation est un circuit numérique commandé par processeur (CC) qui, à l'intérieur de la deuxième zone partielle (AT), détermine une valeur moyenne effective à partir de la courbe de niveau de signal effectif et analyse cette valeur pour la détermination de la valeur d'erreur constante (AE).

4. Amplificateur radiofréquence (PA) selon la revendication 1, caractérisé en ce que le circuit de régulation est un circuit numérique commandé par processeur (CC) qui utilise la valeur d'erreur constante (AE) du segment temporel respectif (T2[k] pour la commande de la courbe de niveau de signal de consigne constante à l'intérieur d'un segment temporel ultérieur (T2[k+1] et qui utilise les valeurs d'erreur constante déterminées de deux segments temporels qui se suivent (Tl[k], T2[k] pour la commande de la courbe de niveau de signal de consigne dynamique à l'intérieur d'un segment temporel ultérieur (T2[k+1] pour adapter la transition d'un niveau de signal au suivant.

5. Amplificateur radiofréquence (PA) selon la revendication 4 pour l'amplification, régulée en puissance, d'un signal radio TDMA qui est constitué de cadres temporels (k-1, k, k+1 ...) qui englobent à chaque fois plusieurs des segments temporels (T1[1], T2[k] ... T8[k]),
caractérisé en ce que
le circuit numérique commandé par processeur (CC) calcule, à partir des valeurs d'erreur constante (AE) qui sont définies à l'intérieur d'un cadre temporel (k), des valeurs de commande et enregistre de façon intermédiaire ces valeurs dans une mémoire de cadres temporels (FMEM) et les utilise pour la commande de la courbe de niveau de signal de consigne à l'intérieur d'un des cadres temporels suivants (k+1) si les courbes de niveau de signal de consigne dans les deux cadres temporels (k, k+1) sont prédéterminées de façon égale, au moins de façon approximative.

6. Amplificateur radiofréquence (PA) selon la revendication 4, caractérisé en ce que le circuit numérique commandé par processeur (CC), lors de la première apparition d'une transition de niveau de signal, calcule, selon une courbe cos², des valeurs de commande dynamique pour l'adaptation de la première zone partielle dynamique (GT; T2[k+1]) aux deuxièmes zones partielles constantes voisines (AT; T1[k+1], T2[k+1]) et consigne ces valeurs de commande dans une mémoire d'initialisation (IMEM) et utilise ces valeurs de commande dynamique à l'intérieur d'une première zone partielle suivante (GT) lors de la nouvelle apparition de cette transition de niveau de signal pour la commande de la courbe de niveau de signal de consigne dynamique.

7. Emetteur radio avec un amplificateur radiofréquence (PA) pour la modification régulée de la courbe de niveau de signal (SL) d'un signal radiofréquence (Pin, Pout) divisé en segments temporels qui se suivent (T1, T2, ..., T8), en particulier d'un signal radio TDMA, et avec un circuit de régulation (CC) qui, à l'intérieur de plusieurs segments partiels (GT, AT) du segment temporel respectif (T1, T2), dans lesquels à chaque fois une courbe de niveau de signal de consigne est prédéterminée, analyse de façon différente la courbe de niveau de signal effectif du signal radiofréquence (Pout),
caractérisé en ce que
le circuit de régulation (CC) dans le segment temporel respectif (Tl[k]; T2[k]) à l'intérieur d'une première zone partielle (GT) dans laquelle une courbe dynamique de niveau de signal de consigne est prédéterminée, n'analyse pas la courbe de niveau de signal effectif et, à l'intérieur d'une deuxième zone partielle (AT) dans laquelle une courbe de niveau de signal de consigne constante est prédéterminée, analyse la courbe de niveau de signal effectif, le circuit de régulation (CC) déterminant une valeur d'erreur constante (AE) au moyen d'une comparaison valeur de consigne/effective.
